# EUROPEAN PATENT APPLICATION

(11) **EP 4 306 981 A1**
(43) Date of publication of application: **17.01.2024**
(21) Application number: 22184862.5
(22) Date of filing: 14.07.2022
(51) Int. Cl.: G01R 33/36, G01R 33/341

(54) **RADIO FREQUENCY RECEIVER COIL WITH ELECTRONIC FUSE**

(71) Applicant: Koninklijke Philips N.V., 5656 AG Eindhoven (NL)
(72) Inventor: LEUSSLER, Christoph Günther, Eindhoven (NL); VERNICKEL, Peter, Eindhoven (NL); FINDEKLEE, Christian, 5656AG Eindhoven (NL)
(74) Representative: Philips Intellectual Property & Standards

(57) **Abstract**

An independent safety mechanism for a radio frequency (RF) receiver coil is to be provided. This is achieved by an electronic fuse (3), the electronic fuse (3) comprising a switching device (4) for interrupting an RF electrical current in the RF coil loop (2) galvanically connected to the RF coil loop (2) and configured to interrupt the RF electrical current in the RF coil loop (2) above a defined threshold. The invention also relates to a method for protecting a radio frequency (RF) receiver coil (1), to a magnetic resonance imaging apparatus and a computer program product.

## Description

### FIELD OF THE INVENTION

The invention relates to the field of radio frequency (RF) receiver coils for magnetic resonance examination systems and, more particularly, to an RF receiver coils with an electronic fuse. The invention further relates to a method for protecting a radio frequency (RF) receiver coil with an electronic fuse and a computer program product.

### BACKGROUND OF THE INVENTION

MR coils are turned on and off using RF switches typically based on PIN diodes. For failure proof design (pin diode drive signal is missing) one has to add a second independent safety mechanism. One ultimate solution for this issue is to place a fuse in the coil, which blows in case of hazardous currents. Conventional fuses protect circuits and prevent equipment destruction by fusing the built-in alloy parts by Joule heat when a current exceeding the rated value flows. However, these fuses have disadvantages such as uncertainty of the breaking current, slow fusing time, and the need for replacement work due to destruction by a single overcurrent. Unfortunately, fuses are not available for the full range of hazardous currents. With the advent of light weight digital RF coils for MRI, coils can be equipped with smart functionality to provide safe clinical workflow. Furthermore, there is a trend to smaller elements in close proximity to the tissue which demands more sensitive fuses than available today.

MR coils for signal reception need to have two operational states:
- An "on" state: Low noise reception state for capturing of very weak (down to noise floor) nuclei signals
- An "off' state: Passive state, in which the coils need to withstand strong RF pulses intended to excite nuclei.

For switching, RF switches based on PIN diodes are typically used. RF currents (induced by the RF transmit pulse) are effectively blocked in the coil loop, if the coil is switched to the appropriate state The functioning of a detune circuit is detected by measuring the DC bias current though and/or voltage across the diode continuously..When the expected values for "on" and "off'-state (current of zero and e.g., 80mA) are not reached, scanning is stopped immediately.. Measurement of the diode current is an indirect indicator for proper functioning but requires additional means for safety. For failsafe use, the individual loop elements in the coil are equipped with passive fuses. The fuses are basically small resistors in series to the coil loop that blow once a current level is exceeded. To maintain high image quality, the resistance of the fuse has to be as low as possible, otherwise the resistor contributes substantially to the thermal noise received by the coil deteriorating the SNR

For flexible RF coils where the coil conductor is relatively close to the human skin (~5mm), comparably low currents can already pose a hazardous situation.

Here passive fuses do not provide a safe 2nd measure due to the fact that fuses with a that low blow current and a low resistance are technically hard/impossible to realize.

The prior art describes several alternatives of electric fuses in RF receiver coils. For example, the document US2013234715A1 describes a magnetic resonance imaging apparatus comprising a transmitting coil, a receiving coil, a balanced to unbalanced transformer (BALUN), an overheat protection circuit, and an imaging control unit. The transmitting coil applies a radio-frequency magnetic field to a subject placed in a static magnetic field. The receiving coil receives a magnetic resonance signal emitted from the subject owing to an application of the radio-frequency magnetic field. The BALUN is connected to the receiving coil and suppresses an unbalanced current induced in the receiving coil. The overheat protection circuit indicates that the BALUN is abnormal when a temperature of the BALUN exceeds a temperature threshold. The imaging control unit stops imaging when the overheat protection circuit indicates an abnormality of the BALUN

There are several problems and disadvantages of passive fuses used in the state of the art. Passive fuses are too slow for thin flexible RF coils. Measurement of the diode current is an indirect indicator for proper functioning (requiring additional means for safety.) Failure mode where the diode gets disconnected from the rest of the coil is not detectable. Failure modes thinkable, where DC current is still flowing while the coil is not effectively detuned causing a hazard to the patient. Passive fuse as fail-safe detection method needs to be replaced when broken.

### SUMMARY OF THE INVENTION

It is an object of the invention to improve the protection of a radio frequency (RF) receiver coil.

According to the invention, this object is addressed by the subject matter of the independent claims. Preferred embodiments of the invention are described in the sub claims.

Therefore, according to the invention, a radio frequency (RF) receiver coil is provided comprising: at least one RF coil loop, at least one electronic fuse, the electronic fuse comprising a switching device for interrupting an RF electrical current in the RF coil loop, wherein the switching device is galvanically connected to the RF coil loop, the electronic fuse further comprising a switching unit for controlling the switching device, wherein the switching device is configured to interrupt the RF electrical current in the RF coil loop by the switching unit above a defined threshold, the RF receiver coil further comprising a local current sensor circuit for measuring the RF electrical current, wherein the electronic fuse is configured to compare an output of the local current sensor circuit with a threshold of the RF electrical current in the RF coil loop for switching the switching device and deactivating the electronic fuse to interrupt the RF electrical current in the RF coil loop if the threshold is exceeded.

Electronic fuses, also known as efuses, are small integrated circuits (ICs) used to replace a conventional fuse in a device. Electronic fuses function similarly to conventional fuses. When an overcurrent or overvoltage is detected, the fuse can be deactivated.

In addition, the electronic fuse is not destroyed by a single overcurrent and can be used repeatedly. efuses are not bound to the physical limitations such as passive fuses, so that a wider range of blow currents and times can be selected while the requirement of low resistance is maintained. This achieves the advantage that maintenance costs and recovery time for repairs of the RF receiver coil or the complete magnetic resonance imaging apparatus are reduced.

In an advantageous embodiment of the invention the electronic fuse is an independent stand-alone component in addition to RF receiver coil electronics.

In another advantageous embodiment of the invention the switching device is a FET and/or a MEM-switch and/or a bipolar junction transistor and/or a PIN-diode. In an embodiment wherein a FET as switching device is used, a charge pump and a gate driver to drive a gate contact of the FET can be foreseen. The efuse can also be a MEM switch. Here if no voltage is present the MEM switch is in a high impedance state. So, if the coil is not connected the coil is safe. The MEM switch can also be used as a FET switch.

In an advantageous embodiment of the invention the radio frequency (RF) receiver coil comprises a digitizer for digitizing the output of the local current sensor circuit and comparing it with a threshold of the RF electrical current in the RF coil loop.

In another advantageous embodiment of the invention the RF receiver coil comprises an additional digitizer for measuring a signal of the gate contact of the FET. The signal of the gate of the electronic fuse can be further detected by a remote digitizer. The magnitude/phase of the detected signal will follow the known transmit pulse envelope. If this is not the case, there may be a problem e.g., that the tank circuit, detuning circuit, capacitors or connections are broken.

In an advantageous embodiment of the invention the electronic fuse is set up in such that when the gate contact of the FET of the electronic fuse is not being driven by the gate driver, the electronic fuse is deactivated, and the RF electrical current cannot flow in the RF coil loop.

In another advantageous embodiment of the invention the electronic fuse is connected in series to the RF coil loop and the FET of the electronic fuse is an enhancement mode MOSFET. Enhancement-mode MOSFETs (metal-oxide-semiconductor FETs) are the common switching elements in most integrated circuits. These devices are off at zero gate-source voltage. NMOS can be turned on by pulling the gate voltage higher than the source voltage, PMOS can be turned on by pulling the gate voltage lower than the source voltage. In most circuits, this means pulling an enhancement-mode MOSFET's gate voltage towards its drain voltage turns it on. Unlike conventional fuses, the efuse IC has a high-speed current interruption function because the built-in MOSFETs are turned off when excessive current flows.

In another advantageous embodiment of the invention the electronic fuse is arranged such that it can be reactivated after a deactivation by an electronic reactivating circuit or by the external digital controller so that the RF electrical current can flow again in the RF coil loop.

In an embodiment of the invention the switching device of the electronic fuse is in series with a conductor of the RF coil loop or the electronic fuse is realized as a parallel detune circuit with the switching device in series. Is the switching device of the electronic fuse is in series with a conductor of the RF coil loop and if there is no DC voltage present, means coil not connected, then the device has a high impedance. The switching device can also be realized as a parallel detune circuit with a switching device in series. A detune circuit with e.g., a diode needs a low impedance device, as the resonant detune circuit provides a high impedance, but only if the device has a low impedance. This parallel resonant circuit has a high impedance and has the same effect as a blown-up fuse. Here high impedance is realized when the device has a low impedance when not supplied.

In a further aspect of the invention, the object is achieved by a magnetic resonance imaging apparatus comprising a radio frequency (RF) receiver coil as described above.

The invention further relates to a method for protecting a radio frequency (RF) receiver coil, wherein the method comprises the following steps:
- providing a radio frequency (RF) receiver coil comprising at least one electronic fuse as described above,
   - detecting the RF electrical current in the RF coil loop by a local current sensor circuit,
   - comparing an output of the local current sensor circuit with a defined threshold value for the RF electrical current in the RF coil loop,
   - switching the switching device by means of the switching unit and deactivating the electronic fuse when the measured RF electrical current exceeds a defined threshold so that the RF electrical current in the RF coil loop is interrupted by the switching device.

In an advantageous embodiment of the invention after the electronic fuse is deactivated by switching the switching device, the electronic fuse stays deactivated and indicates the activation by a signal. This ensures that the RF receiver coil is not accidentally switched on, which could destroy the coil and endanger persons.

In another advantageous embodiment the RF electrical current is detected by an inductive coupler and/or a capacitive voltage divider and/or by a voltage drop over a small value resistor and/or a temperature rise from a small resistor.

In accordance with embodiments of the present invention the radio frequency (RF) receiver coil comprises a preamplifier for amplifying an MRI signal, the method comprising the following additional step:
- measuring an output signal of the preamplifier by a sensor circuit,
- training an artificial intelligence learning algorithm to get a baseline for the sensor circuit and for the threshold of the activation of the electronic fuse.

It is further envisioned that the method comprising the following additional step:
- emitting a preparation pulse before an MRI scan and monitoring the operability of the electronic fuse. By means of a preparation pulse, the fuse can be checked for any damage and for correct operation. This can further increase safety during operation of the magnetic resonance imaging apparatus.

In an advantageous embodiment of the invention the method comprises the following additional step:
- reactivating the RF receiver coil by reactivating the electronic fuse by an independent electronic reactivating circuit or by an external digital controller. The reactivation of the fuse can also be done automatically, so that the electronic fuse is not destroyed by a single overcurrent and can be used repeatedly.

In a further aspect of the invention, the object is achieved by a computer program product comprising instructions to cause the radio frequency (RF) receiver coil to execute the steps of the method as described above.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a radio frequency (RF) receiver coil with an electronic fuse according to an embodiment of the invention,
Fig. 2 shows a flow chart of a method for protecting a radio frequency (RF) receiver coil according to an embodiment of the invention.

### DETAILED DESCRIPTION OF EMBODIMENTS

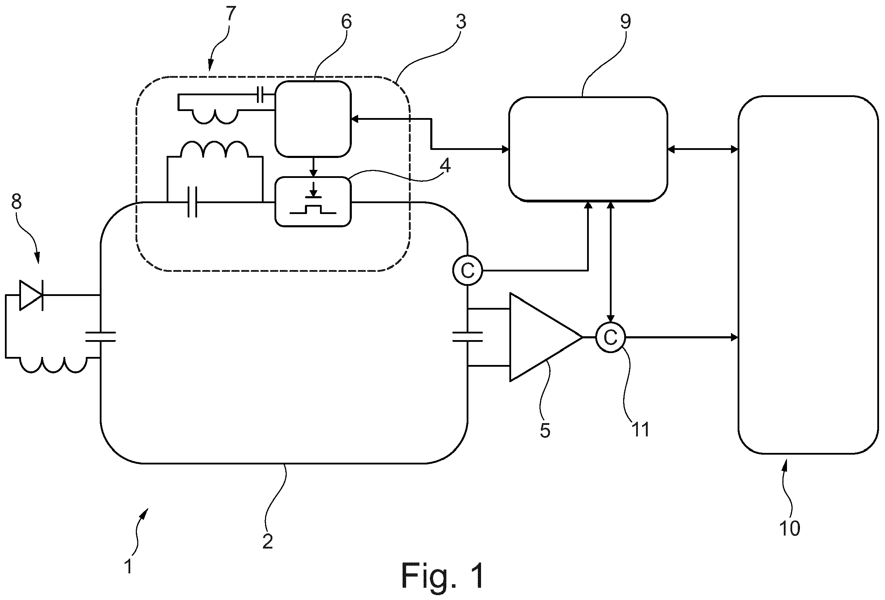

Fig. 1 schematically depicts a radio frequency (RF) receiver coil 1 with an electronic fuse 3 according to an embodiment of the invention. The radio frequency (RF) receiver coil 1 comprises at least one RF coil loop 2 to receive MRI signals. Furthermore, the coil comprises at least one detune circuit 8 connected to the RF coil loop and a preamplifier 5 to amplify the MRI signals. In Fig. 1 an electronic fuse 3 is integrated in the RF coil loop. The electronic fuse 3 is an active circuit protection device with an integrated switching device 4 used to limit currents to safe levels during fault conditions. The switching device 4 is galvanically connected to the RF coil loop 2. The switching device 4 is controlled by switching unit 6. In an embodiment the switching device 4 is a FET and/or a MEM-switch and/or a bipolar junction transistor and/or a PIN-diode. If, for example, a FET is used, the efuse additionally comprises e.g., a charge pump and a gate driver 6 to drive a gate contact of the FET 4. In Fig. 1, in one embodiment of the invention, an FET with a charge pump and a gate driver 6 is shown. The electronic fuse 3 is configured to interrupt an RF electrical current in the RF coil loop 2 above a defined threshold. In one embodiment the electronic fuse 3 is connected in series to the coil loop 2 and the FET 4 of the electronic fuse 3 is an enhancement mode MOSFET. An enhancement mode MOSFET has the advantage that at zero gate-source voltage the MOSFET is switched off. This can, for example, prevent damage to the (RF) receiver coil 1 or even injury to persons in the event of a charge pump or gate driver 6 fault. The RF receiver coil 1 comprises further a local current sensor circuit 7 for measuring the RF electrical current wherein the output of the local current sensor circuit 7 is applied to a digitizer for comparing the signal with a threshold of the RF electrical current in the RF coil loop 2 for switching the FET and deactivating the electronic fuse 3 to interrupt the RF electrical current in the RF coil loop 2 if the threshold is exceeded. For example, a high voltage induced in the RF receiver coil 1, e.g., by the transmit pulse, leads to a high current in the coil loop 2. The current is measured by the local current sensor 7. The electronic fuse 3 is to be understood as an independent component in addition to the RF receiver coil 1 electronics. When the FET of the electronic fuse is activated, the electronic fuse stays deactivated and indicates the deactivation by a signal. The threshold level can be surpassed due to an incorrect positioning of the RF receiver coil 1 or by coupling issues with other coils, sensors, or cables. If this is the case, the magnetic resonance imaging apparatus is stopped, and the coil needs to be checked. In case the coil is not electrically defect, the electronic fuse is reactivated, and an MRI scan can continue. Reactivation of the fuse can be realized by local independent circuit or by an external digital controller e.g., by an electronic fuse detector management 9 shown in Fig. 1. The signal of the gate of the electronic fuse 2 can be further detected by a remote digitizer. The magnitude/phase of the detected signal will follow the known transmit pulse envelope. If this is not the case, the tank circuit or detuning circuits, capacitors, connections may be broken and must be checked.

In an embodiment of the invention the electronic fuse 3 consists of an active switching device 4 using a FET or a MEM switch or SPDT switch, which can be in series with a conductor of the RF coil loop 2 as shown in Fig. 1. Thus, if there is no DC voltage present, means coil 2 not connected, then the device has a high impedance. The switching device 4 can also be realized as a parallel detuning circuit 8 with the switching device 4 in series. The detune circuit 8 with diode shown in Fig. 1 needs a low impedance device, as the resonant detune circuit 8 provides a high impedance, but only if the device has a low impedance. This parallel resonant circuit has a high impedance and has the same effect as a blown-up fuse. Here high impedance is realized, when the device has a low impedance when not supplied. In general, the switching device 4 consist of a FET or MEM switch and can have additional lumped elements components added such as parallel detuning or elements for compensation of complex impedance. The diode shown in Fig. 1 can also represent an actively switching device like a FET and/or MEM and/ or SPDT switch. In embodiments of the invention hazardous currents might be detected by using e.g., an inductive coupler as seen in Fig. 1, or by a capacitive voltage divider. Currents can also be measured by a voltage drop over a small value resistor (e.g., 0.1 Ohm when the coil's loaded resistance is in the order of 5 ohms). Furthermore, a temperature rise from a small resistor can be measured e.g., with a thermocouple or a resistance temperature detector (RTD).

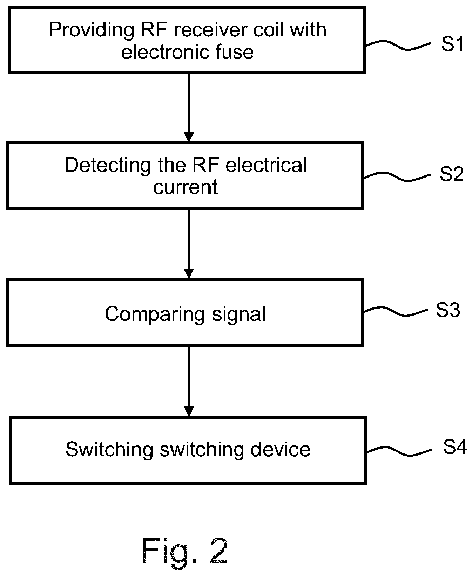

Fig. 2 shows a flow chart of a method for protecting a radio frequency (RF) receiver coil according to an embodiment of the invention. First, in step S1, the previously described radio frequency (RF) receiver coil comprising at least one electronic fuse is provided. The method comprises the following steps. In step S2 the RF electrical current in the RF coil loop 2 is detected by a local current sensor circuit 7. As described above the current might be detected by an inductive coupler and/or a capacitive voltage divider and/or by a voltage drop over a small value resistor and/or a temperature rise from a small resistor. In the following step S3 a signal of the local current sensor circuit 7 is feed to a digitizer which compares the signal with a defined threshold value for the RF electrical current in the RF coil loop 2. When the measured RF electrical current exceeds a defined threshold the switching device 4 is switched by the switching unit 6 in step S3. In an embodiment the switching unit 6 can comprise e.g., a charge pump and a gate driver to drive a gate contact of the FET. Thereby the electronic fuse 3 is deactivated so that the RF electrical current in the RF coil loop 2 is interrupted by the switching device 4. In an embodiment io the invention the electronic fuse 3 stays deactivated and indicates the deactivation by a signal. This then allows further safety measures to be taken. In an embodiment of the invention the complex (or magnitude, envelope) signal of the gate signal (preamplifier output signal) is used to train an Artificial Intelligence (AI) learning algorithm to get a baseline for the complex signal monitor and for the threshold of the deactivation of the electronic fuse 3. Only if the complex RF current is within a defined parameter window, the scan is activated or continued. Before the scan starts, a preparation pulse can be used to monitor the fitness of the electronic fuse 3.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

### REFERENCE SYMBOL LIST

| | |
|---|---|
| radio frequency (RF) receiver coil | 1 |
| RF coil loop | 2 |
| electronic fuse | 3 |
| switching device | 4 |
| preamplifier | 5 |
| switching unit | 6 |
| current sensor circuit | 7 |
| detune circuit | 8 |
| electronic fuse detector management | 9 |
| digital RF coil platform | 10 |
| sensor circuit | 11 |

## Claims

1. A radio frequency (RF) receiver coil (1) comprising:
at least one RF coil loop (2),
at least one electronic fuse (3), the electronic fuse (3) comprising a switching device (4) for interrupting an RF electrical current in the RF coil loop (2), wherein the switching device (4) is galvanically connected to the RF coil loop (2), the electronic fuse (3) further comprising a switching unit (6) for controlling the switching device (4), wherein the switching device (4) is configured to interrupt the RF electrical current in the RF coil loop (2) by the switching unit (6) above a defined threshold,
the RF receiver coil (1) further comprising a local current sensor circuit (7) for measuring the RF electrical current, wherein the electronic fuse (3) is configured to compare an output of the local current sensor circuit (7) with a threshold of the RF electrical current in the RF coil loop (2) for switching the switching device (4) and deactivating the electronic fuse (3) to interrupt the RF electrical current in the RF coil loop (2) if the threshold is exceeded.

2. The radio frequency (RF) receiver coil (1) according to claim 1, wherein the electronic fuse (3) is an independent stand-alone component in addition to RF receiver coil electronics.

3. The radio frequency (RF) receiver coil (1) according to claim 1 or 2, wherein the switching device (4) is a FET and/or a MEM-switch and/or a bipolar junction transistor and/or a PIN-diode.

4. The radio frequency (RF) receiver coil (1) according to any preceding claim , wherein the radio frequency (RF) receiver coil (1) comprises a digitizer for digitizing the output of the local current sensor circuit (7) and comparing it with a threshold of the RF electrical current in the RF coil loop (2).

5. The radio frequency (RF) receiver coil (1) according to any preceding claim, wherein the electronic fuse (3) is set up in such that when the switching device (4) of the electronic fuse (3) is not being driven by the switching unit (6), the electronic fuse (3) is deactivated and the RF electrical current cannot flow in the RF coil loop (2).

6. The radio frequency (RF) receiver coil (1) according to any preceding claim, the RF receiver coil (2) comprising an external digital controller (9) for controlling the electronic fuse (3).

7. The radio frequency (RF) receiver coil (1) according to any preceding claim, wherein the electronic fuse (3) is arranged such that it can be reactivated after a deactivation by an electronic reactivating circuit or by the external digital controller (9) so that the RF electrical current can flow again in the RF coil loop (2).

8. The radio frequency (RF) receiver coil (1) according to any preceding claim, wherein the switching device (4) of the electronic fuse (3) is in series with a conductor of the RF coil loop (2) or the electronic fuse (3) is realized as a parallel detuning circuit (8) with the switching device (4) in series.

9. A magnetic resonance imaging apparatus comprising a radio frequency (RF) receiver coil (1) according to any one of claims 1 to 8.

10. A method for protecting a radio frequency (RF) receiver coil (1), wherein the method comprises the following steps:
- providing a radio frequency (RF) receiver coil (1) comprising at least one electronic fuse (3) according to one of claims 1 to 8,
- detecting the RF electrical current in the RF coil loop (2) by a local current sensor circuit (7),
- comparing an output of the local current sensor circuit (7) with a defined threshold value for the RF electrical current in the RF coil loop (2),
- switching the switching device (4) by means of the switching unit (6) and deactivating the electronic fuse (3) when the measured RF electrical current exceeds a defined threshold so that the RF electrical current in the RF coil loop (2) is interrupted by the switching device (4).

11. The method according to claim 10, wherein after the electronic fuse (3) is deactivated by switching the switching device (4), the electronic fuse (3) stays deactivated and indicates the activation by a signal.

12. The method according to any one of claims 10 or 11, wherein the RF electrical current is detected by an inductive coupler and/or a capacitive voltage divider and/or by a voltage drop over a small value resistor and/or a temperature rise from a small resistor.

13. The method according to any one of claims 10 to 12, wherein the radio frequency (RF) receiver coil (1) comprises a preamplifier (5) for amplifying an MRI signal, the method comprising the following additional step:
- measuring an output signal of the preamplifier (5) by a sensor circuit (11),
- training an artificial intelligence learning algorithm to get a baseline for the sensor circuit (11) and for the threshold of the deactivation of the electronic fuse (3).

14. The method according to any one of claims 10 to 13, the method comprising the following additional step:
- emitting a preparation pulse before an MRI scan and monitoring the operability of the electronic fuse (3).

15. The method according to any one of claims 10 to 14, wherein the method comprises the following additional step:
- reactivating the RF receiver coil (1) by reactivating the electronic fuse (3) by an independent electronic reactivating circuit or by an external digital controller (9).

16. A computer program product comprising instructions to cause the device of any one of claims 1 to 8 to execute the steps of the method of any one of claims 10 to 15.
